# EUROPEAN PATENT SPECIFICATION

(11) **EP 3 474 639 B1**
(45) Date of publication and mention of the grant of the patent: **14.07.2021**
(21) Application number: 17197559.2
(22) Date of filing: 20.10.2017
(51) Int. Cl.: H05K 1/18, H01L 23/538, H05K 1/02, H05K 3/46

(54) **EMBEDDING A COMPONENT INTO A COMPONENT CARRIER BY TRANSFERRING THE COMPONENT INTO A CAVITY BEING ALREADY FILLED WITH FILLING MATERIAL**
EINBETTUNG EINER KOMPONENTE IN EINEN KOMPONENTENTRÄGER DURCH ÜBERTRAGUNG DER KOMPONENTE IN EINEN BEREITS MIT FÜLLMATERIAL GEFÜLLTEN HOHLRAUM
INCORPORATION D'UN COMPOSANT DANS UN SUPPORT DE COMPOSANT EN TRANSFÉRANT LE COMPOSANT DANS UNE CAVITÉ DÉJÀ REMPLIE DE MATÉRIAU DE REMPLISSAGE

(43) Date of publication of application: 24.04.2019
(73) Proprietor: AT & S Austria Technologie & Systemtechnik Aktiengesellschaft, 8700 Leoben-Hinterberg (AT)
(72) Inventor: Ifis, Abderrazzaq, 8700 Leoben (AT); Schrittwieser, Wolfgang, 8605 Kapfenberg (AT)
(74) Representative: Dilg, Haeusler, Schindelmann Patentanwaltsgesellschaft mbH

(56) References cited:
- JP-A- 2008 270 777
- US-A1- 2007 074 900
- US-A1- 2009 091 022
- US-A1- 2014 291 859
- US-A1- 2014 360 760

## Description

### Field of Invention

The present invention relates to the technical field of component carriers. In particular, the present invention relates to a method for manufacturing a component carrier having an embedded component.

### Art Background

In modern electronic manufacturing it is becoming more and more important to embed or integrate an electronic component within a component carrier onto which later an electronic assembly with several electrically interconnected components is built up. For instance, if the embedded electronic component is an RFID component, a traceability of the individual component carrier can be realized through a variety of process steps, in particular process steps for building up electronic circuits onto the component carrier. Such process steps may include solder paste printing, mounting electronic components onto the component carrier e.g. by means of a so called pick and place process, heating up the assembled component carrier in an oven in order to solder the terminals of the mounted electronic components at respective conductor pads. A traceability might be in particular relevant for safety relevant electronic products, e.g. airbag controllers, because it allows to identify a defective electronic product in a unique manner. In case a defect product shows up a specific product recall can be initiated which includes all products which have been manufactured at the same time, with the same feedstock, and/or under similar or the same production conditions.

Embedding electronic components can cause problems not only during manufacturing of component carriers with embedded electronic components but also during an operation of an electronic product comprising a component carrier with an embedded electronic component. This is often caused by thermal stress resulting from different thermal expansion coefficients (i) of semiconductor material, e.g. Silicon, (ii) of adhesive material used for attaching an embedded component in a cavity of the component carrier, and (iii) of a component carrier, e.g. FR4 being frequently used for printed circuit boards (PCB). Further existing (mechanical) problems of component carriers with embedded electronic components are e.g. (a) unwanted warpage, (b) component bending, (c) non uniform thickness. All these problems are more or less related to mechanical stability.

There may be a need for providing a method for manufacturing a component carrier with an embedded component, which component carriers exhibit a high mechanical stability.

JP 2008270777 A discloses a method for manufacturing a component carrier with an embedded component wherein a vacuum chuck is used for mounting the component in a cavity filled with filling material.

### Summary of the Invention

This need may be met by the subject matter according to the independent claim 1.

Advantageous embodiments of the present invention are described by the dependent claims.

According to a first aspect of the invention there is described a method for manufacturing a component carrier having a core structure with an embedded component. The described method comprises (a) providing a support structure; (b) attaching an electronic component at a surface of the support structure; (c) providing a core structure; (d) forming a cavity within the core structure; (e) partially filling the cavity with a predefined amount of filling material; (f) positioning the support structure relative to the core structure in such a manner that the electronic component is transferred into the cavity and is dipped into the filling material partially filling the cavity; (g) curing the filling material such that the component within the cavity is fixed to core structure; and (h) removing the support structure. According to the invention the positioning of the support structure relative to the core structure comprises that the support structure or an adhesive substance formed at the surface of the support structure comes into mechanical contact with the core structure.

The described method is based on the idea that by employing the support structure as a temporary means for handling the electronic component to be embedded, the step of inserting the component into the cavity can be realized in an easy and precise manner. Further, filling the cavity with the filling material before the electronic component has been inserted may allow for an accurate embedding of the component because when inserting the component the body of the component displaces at least partially the filling material. Displaced material may fill any gap between the inserted component and the inner wall(s) of the cavity. Thereby, on the one hand a smooth and on the other hand a reliable embedding can be realized. This may provide in particular the following advantages:
- The height of the finally embedded component with regard to the height respectively the upper edge of the cavity can be adjusted precisely. In particular, the height level of the (upper surface of the) component can be easily and precisely aligned with the upper surface of the core structure. This may be in particular of advantage for further processing steps e.g. by means of a laser.
- The core (together with the embedded component) can be realized with a highly constant thickness.
- By adjusting the size of the cavities and/or the amount of filling material being filled in the respective cavity components with different sizes can be embedded in the same core structure within one and the same pressing cycle.
- Since the adhesive is filled into the cavity before the component is inserted, the process of partially filling the cavity with the filling material is facilitated. This may result in an extremely small number of unwanted bubbles in the filling material, which contributes to a smooth and reliable embedding. Further, the creation of bubbles can be impeded by appropriated degassing process. Such a degassing process can be carried out preferably before the insertion of the component. In the absence of the component the degassing will be more effective.
- Due to the improved mechanical properties being characterized in particular by a minimization of residual stress inside the embedded component (e.g. due to a shrinkage of the filling material) the risk of damaging or even braking the component is minimized.
- An unwanted warpage of the core (with the embedded component) and, as a result, also of the final component carrier, can be prevented effectively.
- By adjusting the size of the cavity to the size of the component to be embedded, the volume of the filling material being employed for the embedding can be minimized. As a consequence, a shrinkage of the filling material will have only a minor effect on the mechanical property which may further contribute to a reduction of unwanted warpage.

In the context of this document the term "component carrier" may particularly denote any support structure which is capable of accommodating, in addition to the embedded electronic component, one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of this document the term "printed circuit board" (PCB) may particularly denote a component carrier which is formed by laminating several electrically conductive layer structures with at least one electrically insulating layer structure, for instance by applying pressure, if desired accompanied by the supply of thermal energy. A PCB may be plate-shaped (i.e. planar), three-dimensionally curved (for instance when manufactured using 3D printing) or may have any other shape. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material such as in particular copper, thereby forming vias as through-hole connections. Apart from one or more components which may be embedded, a PCB is usually configured for accommodating one or more components on one or both opposing surfaces of the plate-shaped printed circuit board. They may be connected to the respective main surface by soldering. A dielectric part of a PCB may be composed of resin with reinforcing fibers such as e.g. glass fibers.

In the context of this document the term "support structure" may be any physical construction having a defined surface which is configured in such a manner that the electronic component can be mounted thereto in a detachable manner. Preferably, the support structure is made or at least comprises a rigid material which makes the support structure more or less stiff. This may allow for a safe and precise handling of the component and in particular a safe and precise insertion of the component into the cavity.

The described forming the cavity within the core structure may be realized by means of any appropriate procedure known to the skilled person. An appropriate procedure may be for instance (a) mechanically removing core material by means of routing, milling, etc., (b) etching, and/or (c) ablating core material by means of electromagnetic radiation, in particular laser radiation. Apart from realizing the cavity by means of a "blind opening" the cavity could also be formed firstly by providing a "through opening" through the entire (thickness of the) core structure and secondly by placing a cover or closure element/material at the bottom surface of the core structure in order to close (at the bottom) the "through opening". An appropriate closure element may be for instance a tape.

The filling material may be any material which is suitable for embedding the electronic component in a mechanically smooth and reliable manner. The filling material may be adhesive filling material with a certain degree of stickiness. Alternatively or in combination the filling material may have a protective and/or shielding property in particular with regard to the embedded electronic component. An appropriate filling material may be resin. The volume of the filling material be chosen such that residues on the top of the core are avoided. In case of a filling material with a high viscosity, a small volume should be applied in order to avoid an unwanted displacement of the respective component within the cavity.

The described positioning of the support structure relative to the core structure (and/or the positioning of the core structure relative to the support structure) may be carried out in such a manner that the electronic component is pressed into the filling material being present in the cavity. The necessary pressing force must be applied between the support structure and the core structure. This pressing procedure is similar to a known molding procedure. The pressure should be strong enough in order to bring (the upper surface of) the component onto a desired height with regard to the height of the cavity.

It is pointed out that the described method may also comprise a formation of not only one but several entities each being used for receiving an embedded component. In this respect it should be clear that for an effective process of transferring the respective number of components into the core structure a corresponding number of electronic components have to be attached to the support structure.

It is further pointed out that the described method can be carried out at different scales. This means that in particular the support structure(s) and/or the core structure(s) may have a size which depends on this scale. For instance the scale may be a so called "card scale" which means that typically only one electronic circuit design is formed on the manufactured component carrier. Further, the scale may be a so called "array scale" which means that several (e.g. 2 to 16) different electronic circuit designs are realized on one and the same manufactured component carrier. Furthermore, the scale may be a so called "panel scale" which means that several (e.g. 2 to 16) arrays each comprising several different electronic circuit designs are formed on one and the same manufactured component carrier being a (large) panel. Thereby, a panel may have a size which can be handled by a known component placement machine.

According to an embodiment of the invention the method further comprises forming a layer structure at a surface of the core structure such that the electronic component is covered with the layer structure.

By covering the component respectively the cavity with the layer structure the "embedding" of the component can be completed. This means that as a result of forming the layer structure the component will be encapsulated (from all sides). Of course, if conductive and/or thermal connections to and/or from the component are necessary, suitable vias can be formed preferably after completing the formation of the layer structure.

It is pointed out that it is also possible to fill only a (small) part of the cavity with the filling material such that when inserting the component into the cavity the cavity is not completely filled with the component body and the filling material. A correspondingly remaining volume of the cavity can also be filled together or during an appropriate relamination process in which the described layer structure is formed or attached to the core structure. Such a multi-step filling of the cavity may significantly lower mechanical stress at and/or in the component and may avoid an unwanted bending or warpage and component cracks.

The described layer structure may comprise at least one layer. Preferably, the formed layer structure comprises at least two layers, wherein one layer is a dielectric layer and the other layer is a conductive or metallic layer. In many embodiments of the invention the conductive or metallic layer is an outer layer of the entirety consisting of the core structure and the layer structure.

It is mentioned that a further layer structure could be formed at the opposing surface of the core structure. This may provide the advantage that the resulting component carrier may exhibit a higher degree of symmetry as compared to a component carrier with only one layer structure. Apart from employing (also) the further layer structure for building up conductor paths such an increased symmetry may result in a reduced tendency for warpage in particular under varying temperatures of the component carrier.

Of course, the layer structure may also comprise a larger number of layers. In case the number of layers is at least four (e.g. two conductive metallic layers and two insulating dielectric layers in an alternating sequence), the (multi)layer structure (on the surface of the core structure) can be formed with different pressing steps. This may provide the advantage that after each pressing step a comparatively short via can be formed in order to generate an electric inter-layer connection. Further, an overall inter-layer connection can be realized without requiring a formation of deep holes (e.g. by laser drilling).

According to a further embodiment of the invention the step of positioning the support structure relative to the core structure is carried out in such a manner that a height level of an upper surface of the electronic component corresponds at least approximately to a height level of an upper surface of the core structure.

By bringing the (upper surfaces) of the component and the core structure to the same height level the component carrier can be realized with a uniform thickness. This also holds in case an additional layer structure is formed (as specified above) because one and the same height level yields a planar surface onto which the additional layer structure is formed. In this respect it should be clear that a planar ground surface promotes a planar layer structure and, as a consequence, also a uniform thickness of the entire component carrier.

It is pointed out that the force required for appropriately positioning the support structure relative to the core structure depends in particular on (a) the size of the cavity, (b) the size of the electric component to be embedded, (c) the amount of filling material which has been filled into the cavity, and (d) the compressibility / elasticity / viscosity of the filling material which has been filled into the cavity. When taking into account these parameters the person skilled in the art will find, at least after some experimental studies, appropriate basic parameters for successfully carrying out the described method.

According to a further embodiment of the invention the method further comprises applying an adhesive substance at the surface of the support structure before attaching the electronic component.

An appropriate adhesive substance may allow for a safe and reliable temporal attachment of the electronic component at the surface of the support structure. Thereby, the adhesiveness of the adhesive substance should be strong enough that on the one hand the electronic component will be reliably attached to the support structure during handling the same. On the other hand the adhesiveness should be small enough that an easy and reliable transfer of the electronic component from the support structure to the core structure can be realized. Descriptively speaking, for the electronic component the holding force provided by the (cured) filling material should be larger than the holding force provided by the adhesive substance. The adhesive substance may be for instance a (two-sided) sticky tape.

It is pointed out that attaching the electronic component at the surface of the support structure may also be realized without an adhesive substance having a certain stickiness. Instead, an appropriate component attachment may also be realized by other means such as e.g. van der Waals forces.

According to a further embodiment of the invention the adhesive substance is applied only within selected regions of the surface of the support structure. This may facilitate the handling of the support structure because when the selected regions are covered with the bodies of components to be embedded and/or with other components (e.g. components being used for mechanically guiding the support structure with respect to the core structure) there is no risk that the support structure will unintentionally adhere to other devices and/or that substances like e.g. dirt unintentionally adheres to the core structure. Specifically, when in the course of positioning the support structure relative to the core structure the two structures come into mechanical contact with each other there will be no sticking between them and the subsequent removing of the support structure will be facilitated.

It is mentioned that a spatial restriction of the adhesive substance to the selected regions can be realized also by means of a spatially selective removal of adhesive substance outside from the selected regions. Thereby, the adhesive substance itself can be removed (mechanically) or the adhesive substance can be treated such that in the respective regions it will no longer be adhesive. This can be realized for instance by using an adhesive substance which is sensitive to a certain treatment which at least partially eliminates the adhesion property. Depending on the type of substance such a treatment may be an exposure with UV light causing a crosslinking within the substance, a treatment with heat and/or a treatment with pressure.

According to a further embodiment of the invention the attaching the electronic component is carried out with a mounting head.

The mounting hand may be any suitable handling device which is configured for temporary holding the component and for placing the same onto a predefined mounting position at the surface of the support structure. For positioning the mounting head an appropriate positioning system can be used.

The mounting head may comprise a suction nozzle, which, with the help of a negative pressure, is capable of temporarily holding the electronic component in a reliable and smooth manner. A person skilled in the art knows how to realize a mounting head because mounting heads as such is commonly known and used e.g. in placement machines.

According to a further embodiment of the invention partially filling the cavity comprises a screen printing procedure. This may allow for an easy and effective transfer of filling material into the respective cavity. Screen printing may be in particular of advantage if within one and the same core structure several cavities (with the same size) are provided which have to be filled with filling material.

It is mentioned that in the field of electronic manufacturing screen printing is a procedure which itself is commonly known. Screen printing is typically used for transferring sticky solder paste onto connection pads of printed circuit boards in order to make them ready for being assembled with surface mount components in a placement machine.

According to a further embodiment of the invention partially filling the cavity comprises dispensing the filling material with a dispenser head. This may allow to adjust precisely the amount of filling material being transferred into the cavity.

For realizing the dispenser head inkjet technology may be used which is a well-proven procedure for transferring precisely a predefined amount of viscous material at a precisely predefined position. Relying on inkjet technology may be in particular of advantage if only one or only a small number of cavities within one core structure have to be filled and/or if the cavities within one core structure have different sizes.

Similarity to a mounting head, also the dispenser head can be positioned or moved by means of an appropriate positioning system. Optionally, both the mounting head and the dispenser head can be operated within one and the same machine, which may be similar to a placement machine.

According to a further embodiment of the invention the method further comprises attaching a registration structure at the surface of the support structure. Thereby, positioning the support structure relative to the core structure comprises monitoring the spatial position of the registration structure with respect to the core structure. This may provide the advantage that positioning the support structure relative to the core structure can be controlled on the basis of the position of the registration structure such that the positioning can be realized in a highly precise manner.

The registration structure may be any structure which can be detected by means of an appropriate detector. Preferably, the registration structure is an optically detectable structure and the detector is a camera. The camera may be a part of a vision system which, in addition to the camera, also comprises an appropriate illumination system. Further preferably, the registration structure may be designed such that a high spatial resolution can be realized. This can be achieved for instance with (optically detectable) cross line structures.

It is mentioned that the registration structure may be an optically detectable (three-dimensional) spatial structure having an appropriate geometry and/or an appropriate marking or label which can be detected by means of an image correlation system. In many applications an image correlation procedure allows for a high precision relative alignment between the support structure and the core structure.

According to a further embodiment of the invention the method further comprises (a) inspecting the electronic component within the cavity and the registration structure; and (b) assessing the quality of the component carrier based on a result of inspecting.

The inspection may be carried out optically. Known Automatic Optic Inspection (AOI) machines could be used. Assessing the quality may be carried out with a data processing device which is connected with an AOI machine or which is included within an AOI machine.

With the described quality management faulty or defective component carriers can be removed from a production process and/or a quality guarantee for component carriers which have a certain quality can be given to costumers. In particular, with the described quality assessment it can be made sure that no electric component is missing.

According to a further embodiment of the invention the method further comprises (a) attaching a first guide structure at the surface of the support structure; and (b) forming a second guide structure at or within the core structure. Thereby, when positioning the support structure relative to the core structure the first guide structure mechanically engages with the second guide structure. This may allow for a precise alignment between the support structure and the core structure such that the component is transferred with a high spatial accuracy preferably within the middle of the respective cavity.

The two guide structures may be any physical structures which are capable of being engaged with each other. The first guide structure may be any appropriate component which is attachable to the surface of the support structure next to the attached component and preferably in the same manner as the electronic component is attached. The second guide structure may be a recess or a further cavity (next to the cavity for the component) being formed within the core structure. Forming the recess or the further cavity may be carried out in the same manner as forming the cavity and preferably within the same process step.

The two guide structures may have, with respect to each other, complementary geometries. The first guide structure may be any elevated structure such as e.g. a bar, a pin, a bolt, etc. and the second guide structure may be a complementary recess.

According to a further embodiment of the invention the core structure is a layered core structure comprising at least one electrically insulating layer and at least one electrically conductive layer. The formed cavity may (vertically) extend over one or more layers. When forming the cavity appropriate procedures should be employed which allow for a removal of the respective material.

According to preferred examples of embodiment the multilayer core structure has two conductive layers being formed on an upper and a lower surface of the core structure. For a higher integration density the multilayer core structure comprises four conductive layers and an appropriate number of dielectric layers in between two conductive layers. Two of the four conductive layers are outer layers and the other two conductive layers are inner conductive layers.

The at least one electrically insulating or dielectric layer may comprises at least one of the group consisting of resin (such as reinforced or non-reinforced resins, for instance epoxy resin or Bismaleimi-de-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoro-ethylene, liquid crystal polymer and/or cyanate ester resins may be implemented in the component carrier as electrically insulating layer structure. It is pointed out that the same materials can also be used for additional layer structures as described above.

The at least one electrically conductive layer may comprise at least one of the group consisting of copper, aluminum, nickel, silver, gold, palladium, and tungsten. Although copper is usually preferred, other materials or coated versions thereof are possible as well, in particular coated with supra-conductive material such as graphene. It is pointed out that the same materials can also be used for additional layer structures as described above.

According to a further embodiment of the invention forming the cavity comprises (a) removing a portion of an upper layer of the core structure; and (b) removing a further portion of a directly subjacent inner layer of the core structure, wherein along a thickness direction of the core structure the two portions overlap with each other.

With the described two-step removal very small and in particular very shallow cavities can be formed in a precise and reliable manner. As a consequence, even for very small respectively thin components a cavity with an appropriate size can be produced. In this respect "appropriate size" may mean that the difference between the volume of the cavity and the volume of the component to be embedded is such that an optimal amount of filling material has to be used for completely feeling the cavity (with the body of the component and the filling material).

Put in descriptive words, the cavities resulting from the described multi-step removal of at least two different layers are "structural recesses". Recesses as such are known from the 2.5D® Technology Platform of AT & S Austria Technologie & Systemtechnik AG.

According to a further embodiment of the invention the cavity has an opening solely at one surface of the core structure.

A cavity being open only from one side and/or being accessible only from one direction has the effect that when filling the cavity with the filling material and in particular when pressing the electronic component into the filling material provided within the cavity it is impossible that filling material escapes from the cavity. This may provide the advantage that the amount of filling material being necessary for an optimal embedding of the component can be controlled in a reliable manner.

According to a further embodiment of the invention the method further comprises (a) forming a further cavity within the core structure, wherein the cavity and the further cavity are accessible from opposing surfaces of the core structure; (b) partially filling the further cavity with a predefined amount of further filling material; and (c) transferring a further electronic component into the further cavity by dipping the further electronic component into the filling material.

Descriptive speaking, the general manufacturing method described above can be extended towards a double sided processing respectively embedding. This may allow for a significant space optimization. Thereby, after embedding the (first) component within the (first) cavity the core structure can be flipped and the (second) further cavity can be filled with the further filling material and the (second) further component can be inserted. The filling material and the further filling material may be the same material or, in particular when components with different sizes are processed, different materials, in particular different resins.

For transferring the (at least two) components one and the same support structure of different support structures may be used.
(A) When using only one support structure the transfer of the components into the respective cavity must be carried out sequentially. In this case the above described flipping of the core structure may be employed.
(B) When using two support structures, i.e. the (first) support structure and a (second) further support structure, one support structure being assigned to a first surface of the core structure and the other support structure being assigned to the opposing second surface of the core structure, an assembly process without flipping the core structure may be preferred. In this case a step of positioning the (first) support structure and a step of positioning the (second) further support structure may be carried out simultaneously. This may mean that the (first) support structure presses against the core structure from the first direction and at the same time the (second) further support structure presses against the core structure from an opposing second direction.

According to a further embodiment of the invention the support structure comprises a transparent material. This may provide the advantage that curing the filling material by means of electromagnetic radiation, in particular UV radiation, can be carried out before the support structure (without the electronic component) is removed from the core structure.

According to a further embodiment of the invention (a) the step of attaching the electronic component at a surface of the support structure and (b) the step of partially filling the cavity with a predefined amount of filling material is carried out simultaneously and/or with or by means of the same machine (structure). This may provide the advantage that the described method respectively the entire component carrier manufacturing process can be completed very quickly. As a result the component carrier production efficiency may be increased significantly.

Last but not least it is mentioned that the electronic component may be selected from a group consisting of an electrically non-conductive inlay, an electrically conductive inlay (such as a metal inlay, preferably comprising copper or aluminum), a heat transfer unit (for example a heat pipe), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element or a ferrimagnetic element, for instance a ferrite core) or may be a paramagnetic element. However, the component may also be a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

### Brief Description of the Drawing

Figures 1a to 1h illustrate a method for manufacturing a component carrier with one embedded electronic component.
Figure 2 shows a component carrier with three embedded electronic components and two layer structures each comprising one electrically insulating layer and one electrically conductive layer.
Figure 3 shows a component carrier with three embedded components and two layer structures each comprising a resin layer being sandwiched between two metal layers.
Figure 4 shows a component carrier with four embedded components having different sizes.
Figures 5a to 5g illustrate a method for manufacturing a component carrier, wherein mechanical guide structures are used for ensuring a proper alignment between support structure and core structure.
Figure 6 shows a component carrier with three embedded components which are electrically contacted by means of vias from different sides.
Figure 7 illustrates a diagram depicting schematically a system for carrying out a method according to an embodiment of the invention.

### Detailed Description

The illustration in the drawing is schematic. It is noted that in different figures, similar or identical elements or features are provided with the same reference signs or with reference signs, which are different from the corresponding reference signs only within the first digit. In order to avoid unnecessary repetitions elements or features which have already been elucidated with respect to a previously described embodiment are not elucidated again at a later position of the description.

Further, spatially relative terms, such as "front" and "back", "above" and "below", "left" and "right", et cetera are used to describe an element's relationship to another element(s) as illustrated in the figures. Thus, the spatially relative terms may apply to orientations in use which differ from the orientation depicted in the figures. Obviously all such spatially relative terms refer to the orientation shown in the figures only for ease of description and are not necessarily limiting as an apparatus according to an embodiment of the invention can assume orientations different than those illustrated in the figures when in use.

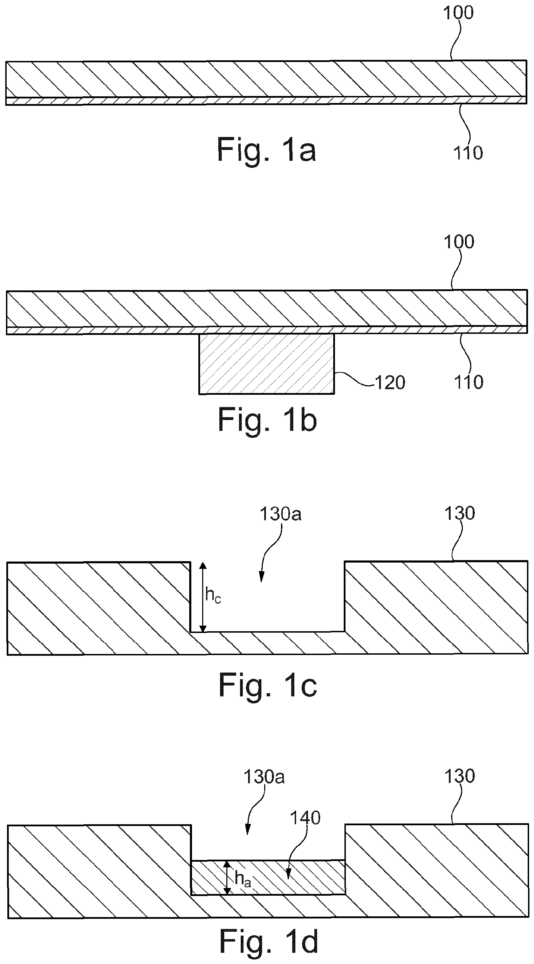

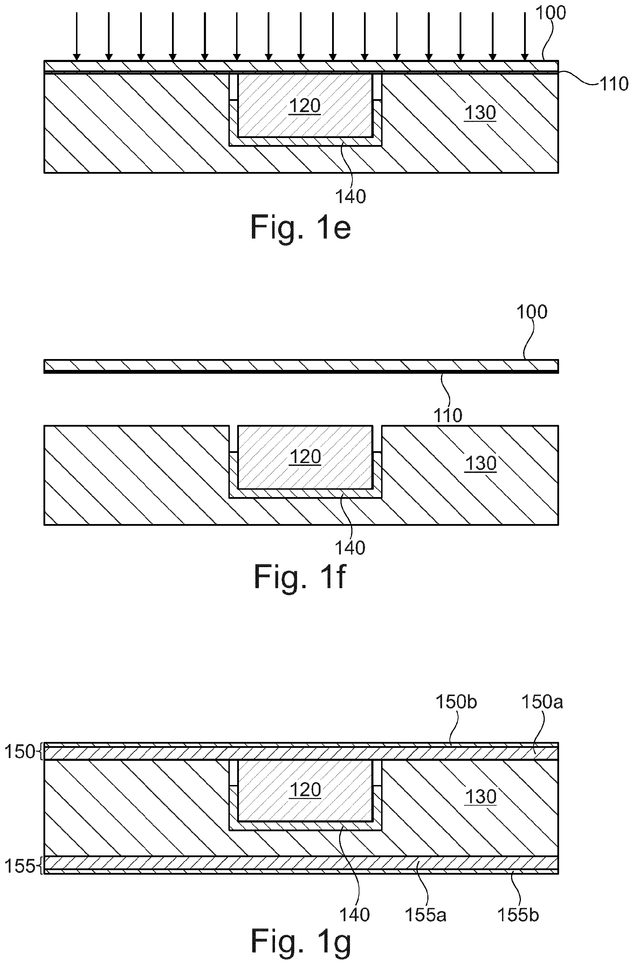

Figures 1a to 1h illustrate a method for manufacturing a component carrier 160. As can be taken from Figure 1a, the method starts with providing a support structure 100 which according to the embodiment described here is a mechanically stiff structure which is shaped as a plate. An adhesive substance 110 is provided at the lower surface of the support structure 100. According to the embodiment described here the adhesive substance 110 is realized by means of a double sided sticky respectively adhesive tape.

As can be taken from Figure 1b, in a next step an electronic component 120 to be embedded is attached to the adhesive substance 110. The stickiness of the adhesive tape 110 is strong enough that during the following handling steps the electronic component 120 will not unintentionally be separated from the support structure 100.

As can be taken from Figure 1c, the described method further comprises providing a core structure 130 with a cavity 130a formed therein. The cavity 130a is dimensioned such that the electronic component 120 can (later) be fully received respectively accommodated. In Figure 1c the height of the cavity 130a is denominated hc.

Next, as can be taken from Figure 1d, the cavity 130a is partially filled with a filling material 140. The corresponding height level of the filling material 140 is denominated ha. The inserted volume of the filling material 140 depends on the cavity size and on the desired covered height of the electronic component 120.

According to the exemplary embodiment described here the filling material is a resin 140. The insertion of the filling material 114 can be carried out in many different manners. Exemplary procedures for the filling material insertion are screen printing and an over the air transfer of the filling material which transfer is accomplished by means of inkjet technology.

As can be taken from Figure 1e, the described method continues with positioning the support structure 100 (together with the attached electronic component 120) relative to the core structure 130 respectively the cavity 130a such that the electronic component 120 enters the cavity 130a. Thereby, the electronic component 120 will come into contact with the filling material 140. At least when pressing the support structure 100 (the corresponding forces are illustrated in Figure 1e with the vertical arrows) a certain amount of filling material 140 will be displaced by the body of the electronic component 120.

After having placed the electronic component 120 at the desired height level, the filling material 114 is cured. Thereby, the electronic component 120 is getting fastened to the core structure 130. Thereby, the corresponding retaining force is much larger than the (pulling) force which can be applied to the electronic component 120 by means of the adhesive substance 110. The step of curing is not illustrated in the drawing. It is only mentioned that depending on the used filling material curing can be realized e.g. by means of (a) pressure, (b) UV radiation (impinging onto the filling material 140 through the support structure 100 being transparent), (c) a heat treatment, etc.

After having cured the filling material 140 the support structure 100 is removed from the core structure 130. This is illustrated in Figure If. This process depends on the type of the used adhesive substance 110. In case of a pressure sensitive adhesive substance 110 the support structure 100 may be automatically removed from the electronic component 120 when releasing the pressure. In case of a UV sensitive adhesive substance 110 an UV exposure step may be required. In case of a temperature sensitive adhesive substance 110 the support structure 100 may be released already during the curing process of the filling material 140.

As can be taken from Figure 1g, the method according to the embodiment described here continues with a relamination, wherein at the top of the core structure 130 there is formed a layer structure 150 and at the bottom of the core structure 130 there is formed a further layer structure 155. Both layer structures 150, 155 comprise a laminate consisting of one electrically insulating layer 150a, 155a comprising resin and one electrically conductive layer 150b, 155b. It is mentioned that in other embodiments of the invention the two laminates 150, 155 comprise a different number of electrically insulating and/or electrically conductive layers.

In a final step the two laminates 150, 155 are pressed against the core structure 130. As can be taken from Figure 1e, the pressure causes the resin of the electrically insulating layer 150a to enter the remaining empty volume of the cavity. At the end, the electronic component 120 will be completely surrounded by the filling material 140 respectively the filling material taken from the resin of the electrically insulating layer 150a.

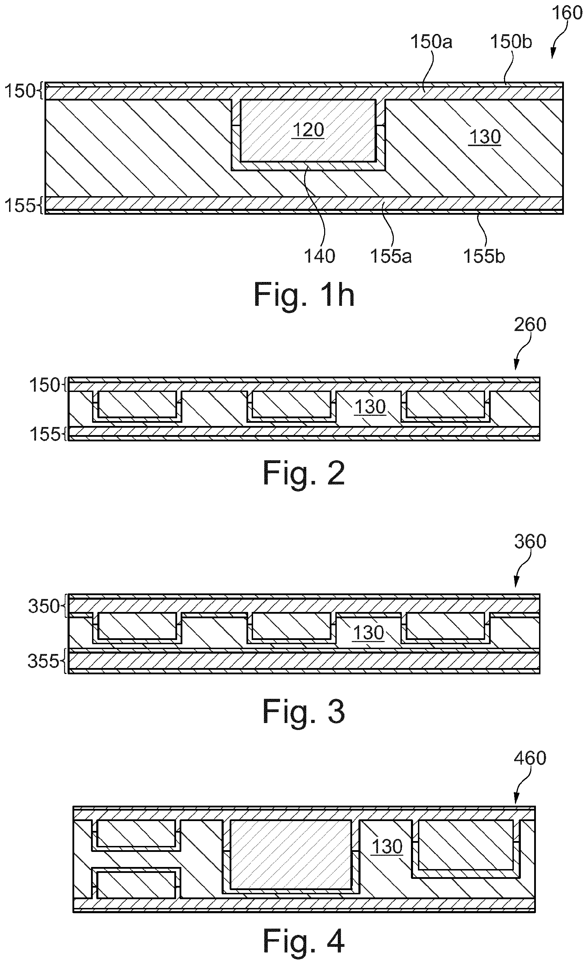

Figure 2 shows a component carrier 260 with three embedded electronic components (not denominated with reference numerals) and two layer structures 150, 155 each comprising one electrically insulating resin layer and one electrically conductive metallic layer. One layer structure 150 is formed above the core structure 130 and the other layer structure 155 is formed below the core structure 130 of the component carrier 260.

Figure 3 shows a component carrier 360 with three embedded components (again not denominated with reference numerals) and two layer structures 350, 355 each comprising an electrically insulating resin layer being sandwiched between two electrically conductive metal layers. As can be seen from Figure 3, the lower metal layer of the layer structure 350 is structured in such a manner that upon pressurizing the entire laminate a part of the resin of the resin layer of the layer structure 350 can enter (empty space within) the cavity.

Figure 4 shows a component carrier 460 with four embedded components. Three components each having a different size are embedded in the core structure 130 in such a manner that an upper surface of the respective component is aligned with an upper surface of the core structure 130. One component is embedded in such a manner that its lower surface is aligned with the lower surface of the core structure 130.

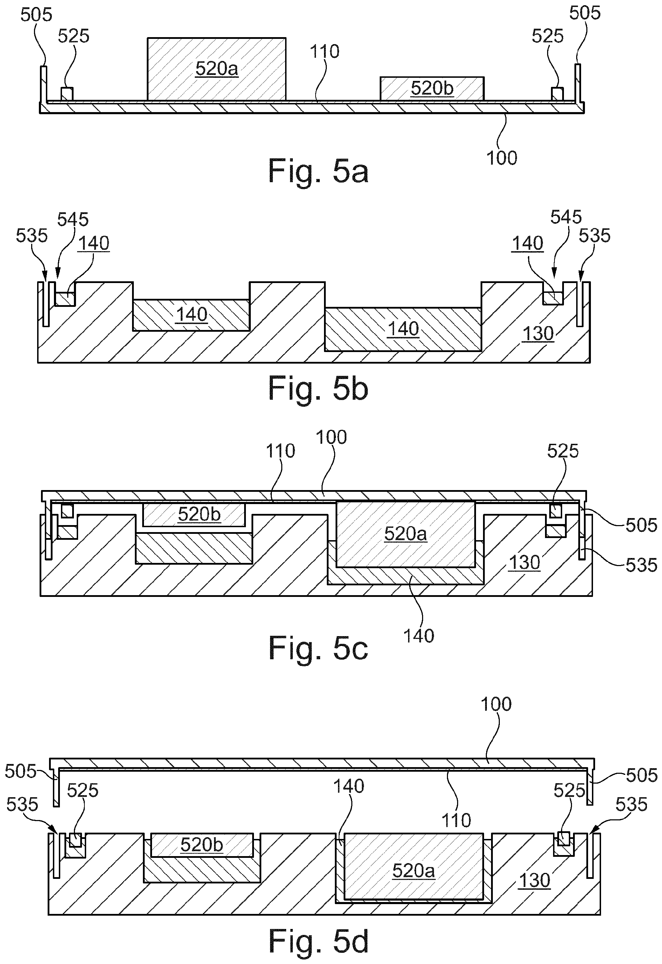

Figures 5a to 5g illustrate a method for manufacturing a component carrier, wherein mechanical guide structures 505, 535 are used for ensuring a proper alignment between the support structure 100 and the core structure 130 when inserting the electronic components into cavities formed within the core structure 130.

As can be taken from Figure 5a, two electronic components 520a, 520b are attached to the adhesive substance 110 being applied at the upper surface of the support structure 100. Further, at the lateral ends of the support structure 100 there are provided two guide structures 505. According to the embodiment described here the two guide structures are realized as respectively one pin 505. Further, a registration structure 525 is attached to the support structure respectively the adhesive substance 110.

As can be taken from Figure 5b, the core structure 130 is formed in a spatial complementary manner with respect to the entirety of the support structure 100 and its various buildups 505, 525, 520a and 520b. Specifically, apart from two cavities being assigned to the electronic components 520a, 520b the core structure 130 comprises two guide structures 535 which are realized by means of two recesses. Further, two further recesses 545 are formed within the core structure 130, wherein the two further recesses 545 are assigned to the two registration structures 525.

As can be seen from Figure 5c, the recesses 535 are dimensioned in such a manner that they engage mechanically with the pins 505 when the support structure 100 together with the two electronic components 520a, 520b is lowered towards the core structure 130 (in order to transfer the electronic components 520a, 520b into the respective cavity). Thereby, the complementary guide structures 505 and 535 make sure that when bringing the support structure 100 and the core structure 130 together a proper alignment of these structures 100, 130 will be maintained.

In order to initially align the support structure 100 with the core structure 130 such that an engagement between the complementary guide structures 505 and 535 takes place, the registration structures 525 and the further recesses 545 are provided. Both the registration structures 525 and the further recesses 545 can be optically captured by means of an appropriate camera system (not depicted). Such a camera system provides positional information to an also not depicted positioning system which brings the support structure 100 and/or the core structure 130 in a relative position that an engagement will take place when bringing the support structure 100 and the core structure 130 together.

After having transferred the electronic components 520a, 520b into the respective cavity the filling material 140 is cured in the same manner as described above with reference to Figure 1e. Further, the adhesiveness of the adhesive substance 110 is reduced as described above with reference to Figure If. Thereafter, as can be seen from Figure 5d, the support structure 100 is removed from the core structure 130. Thereby, according to the exemplary embodiment described here the registration structures 525 remain with the further recess 545.

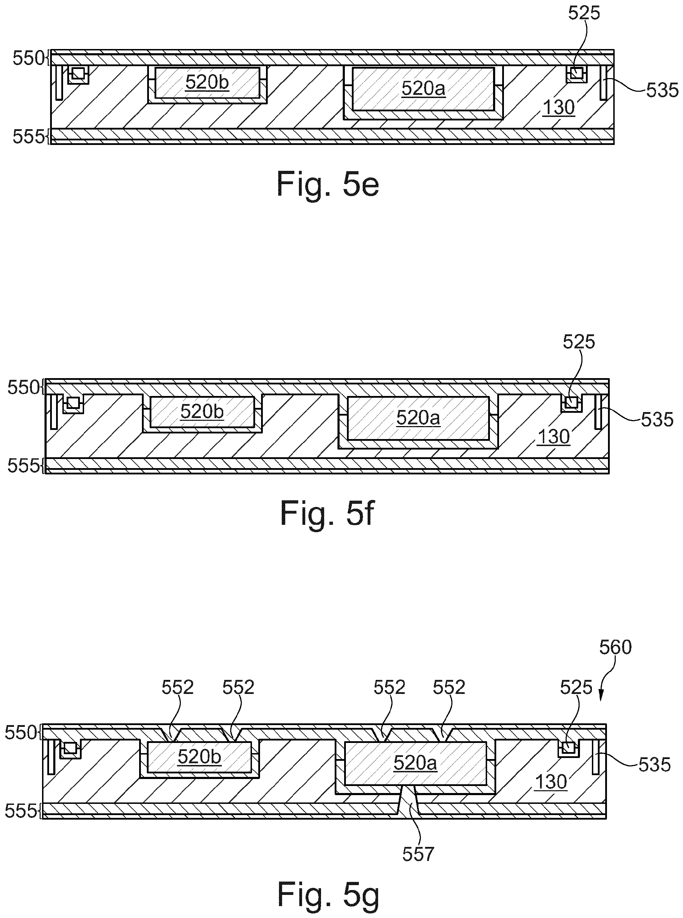

Figures 5e and 5f show further process steps for manufacturing a component carrier. Since these process steps fully correspond to the process steps elucidated above with reference to the Figures 1g and 1h, respectively, they will not be described in detail.

Figure 5g shows the resulting component carrier 560. The core structure 130 is relaminated with two layer structures 550, 555 each comprising an inner resin layer and an outer metal layer. Electric connections between the outer metal layers and the electronic components 520a, 520b are realized by means of metallized vias 552 respectively 557. An upper

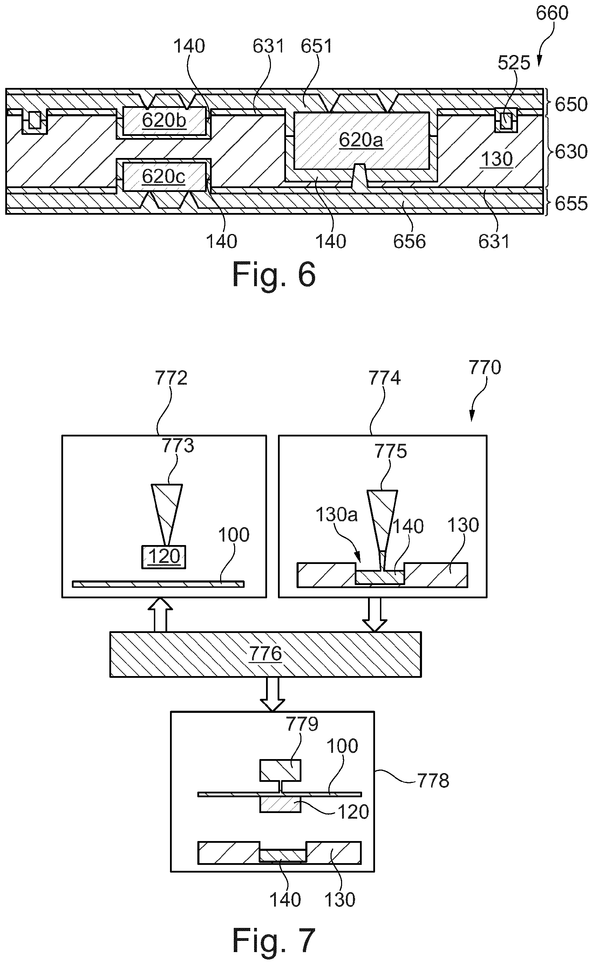

Figure 6 shows a component carrier 660 with three embedded electronic components 620a, 620b, 620c, which are electrically contacted by means of vias from different sides. The component 620a is contacted from two sides, the component 620b is contacted solely from the upper side, and the component 620c is contacted solely from the lower side.

The component carrier 600 comprises a multilayer core structure 630 which comprises the core structure 130 and two metal layers 631. Further, the component carrier 660 comprises two layer structures 650, 655, which respectively represent a relaminate for the multilayer core structure 630. The layer structure 650 comprises a metal layer and a resin layer being denominated with reference numeral 651. The layer structure 655 comprises a metal layer and a resin layer being denominated with reference numeral 656.

Figure 7 illustrates a diagram depicting schematically an embedding system 770 for carrying out a method according to an embodiment of the invention. A first part 772 of the embedding system 770 is an assembly system. The assembly system 772, which may be realized by means of or may be similar to (a part of) a known placement machine, comprises a mounting head 773 for placing the component 120 onto the support structure 100. A second part 774 of the embedding system 770 is a filling system for inserting filling material 140 into cavities 130a formed within the core structure 130. In order to realize an automatic transfer of filling material 140 the filling system774 comprises a controllable dispenser head 775.

A data processing system captures and processes process data from the two systems 772 and 774 and controls a third part 778 of the embedding system 770. This third part is a mechanical loading system 778 comprising an actuator 779 and not depicted handling devices for bringing the support structure 100 and the core structure 130 together. The controllable actuator 779 is configured for applying (from the top side) a force onto the support structure 100 such that a predefined pressure develops between the support structure 100 and the core structure 130. As has already been elucidated above, this pressure may be used for curing the filling material 140 such that the electronic component 120 is embedded within the resulting component carrier in a mechanically stable and smooth manner.

It should be noted that the term "comprising" does not exclude other elements or steps and the use of articles "a" or "an" does not exclude a plurality. Also elements described in association with different embodiments may be combined. It should also be noted that reference signs in the claims should not be construed as limiting the scope of the claims.

### List of reference signs:

- 100: support structure
- 110: adhesive substance / adhesive tape
- 120: electronic component
- 130: core structure
- 130a: cavity
- 140: filling material / resin
- 150: layer structure
- 150a: electrically insulating layer / resin layer
- 150b: one electrically conductive layer / metal layer
- 155: layer structure
- 155a: electrically insulating layer / resin layer
- 155b: one electrically conductive layer / metal layer
- 160: component carrier
- 260: component carrier
- 350: layer structure
- 355: layer structure
- 360: component carrier
- 460: component carrier
- 505: first guide structure / pin
- 520a: electronic component
- 520b: electronic component
- 525: registration structure
- 535: second guide structure / recess
- 545: further recess
- 550: layer structure
- 552: vias
- 555: layer structure
- 557: via
- 560: component carrier
- 620a: electronic component
- 620b: electronic component
- 620c: electronic component
- 630: multilayer core structure
- 631: metal layers
- 650: layer structure
- 651: resin layer
- 655: layer structure
- 656: resin layer
- 660: component carrier
- 770: embedding system
- 772: first part / assembly system
- 773: mounting head
- 774: second part / filling system
- 775: dispenser head
- 776: data processing system
- 778: third part / mechanical loading system
- 779: actuator

## Claims

1. A method for manufacturing a component carrier (160) having a core structure (130) with an embedded component (120), the method comprising
providing a support structure (100);
attaching an electronic component (120) at a surface of the support structure (100);
providing a core structure (130);
forming a cavity (130a) within the core structure (130);
partially filling the cavity (130a) with a predefined amount of filling material (140);
positioning the support structure (100) relative to the core structure (130) in such a manner that the electronic component (120) is transferred into the cavity (130a) and is dipped into the filling material (140);
curing the filling material (140) such that the component (120) within the cavity (130a) is fixed to core structure (130); and
removing the support structure (100);
**characterized in that** the positioning of the support structure (100) relative to the core structure (130) comprises that the support structure (100) or an adhesive substance (110) formed at the surface of the support structure (100) comes into mechanical contact with the core structure (130).

2. The method as set forth in the preceding claim, further comprising
forming a layer structure (150) at a surface of the core structure (130) such that the electronic component (120) is covered with the layer structure (150).

3. The method as set forth in any one of the preceding claims, wherein positioning the support structure (100) relative to the core structure (130) is carried out in such a manner that
a height level of an upper surface of the electronic component (120) corresponds at least approximately to a height level of an upper surface of the core structure (130).

4. The method as set forth in any one of the preceding claims, further comprising
applying an adhesive substance (110) at the surface of the support structure (100) before attaching the electronic component (120).

5. The method as set forth in the preceding claim, wherein
the adhesive substance (110) is applied only within selected regions of the surface of the support structure (100).

6. The method as set forth in any one of the preceding claims, wherein attaching the electronic component (120) is carried out with a mounting head (773).

7. The method as set forth in any one of the preceding claims 1 to 6, wherein partially filling the cavity (130a) comprises a screen printing procedure.

8. The method as set forth in any one of the preceding claims 1 to 6, wherein partially filling the cavity comprises dispensing the filling material (140) with a dispenser head (775).

9. The method as set forth in any one of the preceding claims, further comprising
attaching a registration structure (525) at the surface of the support structure (100); wherein
positioning the support structure (100) relative to the core structure (130) comprises monitoring the spatial position of the registration structure (525) with respect to the core structure (130).

10. The method as set forth in the preceding claim, further comprising
inspecting the electronic component (120) within the cavity (130a) and the registration structure (525); and
assessing the quality of the component carrier (560) based on a result of inspecting.

11. The method as set forth in any one of the preceding claims, further comprising
attaching a first guide structure (505) at the surface of the support structure (100); and
forming a second guide structure (535) at or within the core structure (130); wherein
when positioning the support structure (100) relative to the core structure (130) the first guide structure (505) mechanically engages with the second guide structure (535).

12. The method as set forth in any one of the preceding claims, wherein
the core structure is a layered core structure (630) comprising at least one electrically insulating layer (130) and at least one electrically conductive layer (631) .

13. The method as set forth in the preceding claim, wherein forming the cavity (130a) comprises
removing a portion of an upper layer (631) of the core structure (630); and
removing a further portion of a directly subjacent inner layer of the core structure (630), wherein along a thickness direction of the core structure (630) the two portions overlap with each other.

14. The method as set forth in any one of the preceding claims, wherein the cavity (130a) has an opening solely at one surface of the core structure (130).

15. The method as set forth in any one of the preceding claims, further comprising
forming a further cavity within the core structure (130), wherein the cavity and the further cavity are accessible from opposing surfaces of the core structure (130);
partially filling the further cavity with a predefined amount of further filling material (140); and
transferring a further electronic component (620c) into the further cavity by dipping the further electronic component (620c) into the filling material (140).

16. The method as set forth in any one of the preceding claims, wherein the support structure (100) comprises a transparent material.

17. The method as set forth in any one of the preceding claims, wherein attaching the electronic component (120) at a surface of the support structure (100) and partially filling the cavity (130a) with a predefined amount of filling material (140) is carried out simultaneously and/or by means of the same machine structure.

## Patentansprüche

1. Verfahren zum Herstellen eines Komponententrägers (160), der eine Kernstruktur (130) mit einer eingebetteten Komponente (120) hat, das Verfahren aufweisend
Bereitstellen einer Stützstruktur (100);
Anbringen einer elektronischen Komponente (120) an einer Oberfläche der Stützstruktur (100);
Bereitstellen einer Kernstruktur (130);
Ausbilden eines Hohlraums (130a) innerhalb der Kernstruktur (130); teilweises Füllen des Hohlraums (130a) mit einer vorgegebenen Menge eines Füllmaterials (140);
Positionieren der Stützstruktur (100) relativ zu der Kernstruktur (130) derart, dass die elektronische Komponente (120) in den Hohlraum (130a) überführt und in das Füllmaterial (140) eingetaucht wird;
Aushärten des Füllmaterials (140), so dass die Komponente (120) innerhalb des Hohlraums (130a) zu der Kernstruktur (130) fixiert wird; und
Entfernen der Stützstruktur (100);
**dadurch gekennzeichnet, dass** das Positionieren der Stützstruktur (100) relativ zu der Kernstruktur (130) aufweist, dass die Stützstruktur (100) oder eine an der Oberfläche der Stützstruktur (100) gebildete Haftsubstanz (110) in mechanischen Kontakt mit der Kernstruktur (130) kommt.

2. Verfahren nach dem vorangehenden Anspruch, ferner aufweisend
Ausbilden einer Schichtstruktur (150) an einer Oberfläche der Kernstruktur (130), so dass die elektronische Komponente (120) mit der Schichtstruktur (150) bedeckt ist.

3. Verfahren nach einem der vorangehenden Ansprüche, wobei
das Positionieren der Stützstruktur (100) relativ zu der Kernstruktur (130) derart durchgeführt wird, dass
ein Höhenniveau einer oberen Oberfläche der elektronischen Komponente (120) zumindest näherungsweise einem Höhenniveau einer oberen Oberfläche der Kernstruktur (130) entspricht.

4. Verfahren nach einem der vorangehenden Ansprüche, ferner aufweisend
Aufbringen einer Haftsubstanz (110) auf die Oberfläche der Stützstruktur (100) vor dem Anbringen der elektronischen Komponente (120).

5. Verfahren nach dem vorangehenden Anspruch, wobei
die Haftsubstanz (110) nur innerhalb ausgewählter Bereiche der Oberfläche der Stützstruktur (100) aufgebracht wird.

6. Verfahren nach einem der vorangehenden Ansprüche, wobei
das Anbringen der elektronischen Komponente (120) mit einem Montagekopf (773) durchgeführt wird.

7. Verfahren nach einem der vorangehenden Ansprüche 1 bis 6, wobei
das teilweise Füllen des Hohlraums (130a) eine Siebdruckprozedur aufweist.

8. Verfahren nach einem der vorangehenden Ansprüche 1 bis 6, wobei
das teilweise Füllen des Hohlraums aufweist ein Dispensieren des Füllmaterials (140) mit einem Dispensierkopf (775).

9. Verfahren nach einem der vorangehenden Ansprüche, ferner aufweisend
Anbringen einer Ausrichtungsstruktur (525) an der Oberfläche der Stützstruktur (100); wobei
das Positionieren der Stützstruktur (100) relativ zu der Kernstruktur (130) aufweist ein Überwachen der räumlichen Position der Ausrichtungsstruktur (525) in Bezug auf die Kernstruktur (130).

10. Das Verfahren nach dem vorangehenden Anspruch, ferner aufweisend
Prüfen der elektronischen Komponente (120) innerhalb des Hohlraums (130a) und der Ausrichtungsstruktur (525); und
Beurteilen der Qualität des Komponententrägers (560) basierend auf einem Ergebnis des Prüfens.

11. Verfahren nach einem der vorangehenden Ansprüche, ferner aufweisend
Anbringen einer ersten Führungsstruktur (505) an der Oberfläche der Stützstruktur (100); und
Ausbilden einer zweiten Führungsstruktur (535) an oder innerhalb der Kernstruktur (130); wobei
beim Positionieren der Stützstruktur (100) relativ zu der Kernstruktur (130) die erste Führungsstruktur (505) mechanisch in die zweite Führungsstruktur (535) eingreift.

12. Verfahren nach einem der vorangehenden Ansprüche, wobei
die Kernstruktur eine geschichtete Kernstruktur (630) ist, die mindestens eine elektrisch isolierende Schicht (130) und mindestens eine elektrisch leitende Schicht (631) aufweist.

13. Verfahren nach dem vorangehenden Anspruch, wobei das Ausbilden des Hohlraums (130a) aufweist
Entfernen eines Teils einer oberen Schicht (631) der Kernstruktur (630); und
Entfernen eines weiteren Teils einer direkt darunter liegenden inneren Schicht der Kernstruktur (630), wobei entlang einer Dickenrichtung der Kernstruktur (630) die beiden Abschnitte einander überlappen.

14. Verfahren nach einem der vorangehenden Ansprüche, wobei
der Hohlraum (130a) nur an einer Oberfläche der Kernstruktur (130) eine Öffnung hat.

15. Verfahren nach einem der vorangehenden Ansprüche, ferner aufweisend
Ausbilden eines weiteren Hohlraums innerhalb der Kernstruktur (130), wobei der Hohlraum und der weitere Hohlraum von gegenüberliegenden Oberflächen der Kernstruktur (130) zugänglich sind;
teilweises Füllen des weiteren Hohlraums mit einer vorgegebenen Menge an weiterem Füllmaterial (140); und
Übertragen einer weiteren elektronischen Komponente (620c) in den weiteren Hohlraum durch Eintauchen der weiteren elektronischen Komponente (620c) in das Füllmaterial (140).

16. Verfahren nach einem der vorangehenden Ansprüche, wobei
die Stützstruktur (100) ein transparentes Material aufweist.

17. Verfahren nach einem der vorangehenden Ansprüche, wobei
das Anbringen der elektronischen Komponente (120) an einer Oberfläche der Stützstruktur (100) und das teilweise Füllen des Hohlraums (130a) mit einer vorgegebenen Menge an Füllmaterial (140) gleichzeitig und/oder mittels derselben Maschinenstruktur durchgeführt wird.

## Revendications

1. Un procédé de fabrication d'un support de composant (160) ayant une structure centrale (130) avec un composant intégré (120), le procédé comprenant
le fait de prévoir une structure de support (100) ;
le fait de fixer un composant électronique (120) au niveau d'une surface de la structure de support (100) ;
le fait de prévoir une structure centrale (130) ;
le fait de former une cavité (130a) à l'intérieur de la structure centrale (130) ;
le fait de remplir partiellement la cavité (130a) avec une quantité prédéfinie de matériau de remplissage (140) ;
le fait de positionner la structure de support (100) par rapport à la structure centrale (130) de telle manière que le composant électronique (120) soit transféré dans la cavité (130a) et soit plongé dans le matériau de remplissage (140) ;
le fait de durcir le matériau de remplissage (140) de telle sorte que le composant (120) à l'intérieur de la cavité (130a) soit fixé à la structure centrale (130) ; et
le fait de retirer la structure de support (100) ;
**caractérisé en ce que** le positionnement de la structure de support (100) par rapport à la structure centrale (130) comprend le fait que la structure de support (100) ou une substance adhésive (110) formée au niveau de la surface de la structure de support (100) vient en contact mécanique avec la structure centrale (130).

2. Le procédé selon la revendication précédente, comprenant en outre
le fait de former une structure de couche (150) au niveau d'une surface de la structure centrale (130) de telle sorte que le composant électronique (120) soit recouvert par la structure de couche (150).

3. Le procédé selon l'une quelconque des revendications précédentes, dans lequel le positionnement de la structure de support (100) par rapport à la structure centrale (130) est réalisé de telle manière qu'un niveau de hauteur d'une surface supérieure du composant électronique (120) correspond au moins approximativement à un niveau de hauteur d'une surface supérieure de la structure centrale (130).

4. Le procédé selon l'une quelconque des revendications précédentes, comprenant en outre
le fait d'appliquer une substance adhésive (110) à la surface de la structure de support (100) avant de fixer le composant électronique (120).

5. Le procédé selon la revendication précédente, dans lequel
la substance adhésive (110) est appliquée uniquement dans des zones sélectionnées de la surface de la structure de support (100).

6. Le procédé selon l'une quelconque des revendications précédentes, dans lequel la fixation du composant électronique (120) est réalisée au moyen d'une tête de montage (773).

7. Le procédé selon l'une quelconque des revendications précédentes 1 à 6, dans lequel le remplissage partiel de la cavité (130a) comprend une procédure de sérigraphie.

8. Le procédé selon l'une quelconque des revendications précédentes 1 à 6, dans lequel le remplissage partiel de la cavité comprend le fait de distribuer le matériau de remplissage (140) avec une tête de distribution (775).

9. Le procédé selon l'une quelconque des revendications précédentes, comprenant en outre
le fait de fixer une structure d'enregistrement (525) au niveau de la surface de la structure de support (100) ;
le positionnement de la structure de support (100) par rapport à la structure centrale (130) comprenant le fait de surveiller la position spatiale de la structure d'enregistrement (525) par rapport à la structure centrale (130).

10. Le procédé selon la revendication précédente, comprenant en outre
le fait d'inspecter le composant électronique (120) à l'intérieur de la cavité (130a) et de la structure d'enregistrement (525) ; et
le fait d'évaluer la qualité du support de composant (560) sur la base d'un résultat d'inspection.

11. Le procédé selon l'une quelconque des revendications précédentes, comprenant en outre
le fait de fixer une première structure de guidage (505) à la surface de la structure de support (100) ; et
le fait de former une deuxième structure de guidage (535) au niveau ou à l'intérieur de la structure centrale (130) ;
lors du positionnement de la structure de support (100) par rapport à la structure centrale (130), la première structure de guidage (505) venant mécaniquement en engagement avec la deuxième structure de guidage (535).

12. Le procédé selon l'une quelconque des revendications précédentes, dans lequel la structure centrale est une structure centrale en couches (630) comprenant au moins une couche électriquement isolante (130) et au moins une couche électriquement conductrice (631).

13. Le procédé selon la revendication précédente, dans lequel la formation de la cavité (130a) comprend
le fait de retirer une partie d'une couche supérieure (631) de la structure centrale (630) ; et
le fait d'enlever une partie supplémentaire d'une couche interne directement sous-jacente de la structure centrale (630), les deux parties se chevauchant selon une direction d'épaisseur de la structure centrale (630).

14. Le procédé selon l'une quelconque des revendications précédentes, dans lequel la cavité (130a) a une ouverture uniquement au niveau d'une surface de la structure centrale (130).

15. Le procédé selon l'une quelconque des revendications précédentes, comprenant en outre
le fait de former une autre cavité à l'intérieur de la structure centrale (130), dans laquelle ladite cavité et ladite autre cavité sont accessibles depuis des surfaces opposées de la structure centrale (130) ;
le fait de remplir partiellement ladite autre cavité avec une quantité prédéfinie de matériau de remplissage supplémentaire (140) ; et
le fait de transférer un autre composant électronique (620c) dans ladite autre cavité en plongeant l'autre composant électronique (620c) dans le matériau de remplissage (140).

16. Le procédé selon l'une quelconque des revendications précédentes, dans lequel la structure de support (100) comprend un matériau transparent.

17. Le procédé selon l'une quelconque des revendications précédentes, dans lequel la fixation du composant électronique (120) au niveau d'une surface de la structure de support (100) et le remplissage partiel de la cavité (130a) avec une quantité prédéfinie de matériau de remplissage (140) est réalisé simultanément et / ou au moyen de la même structure de machine.
